# EUROPEAN PATENT APPLICATION

(11) **EP 0 614 230 A2**
(43) Date of publication of application: **07.09.1994**
(21) Application number: 94103234.4
(22) Date of filing: 03.03.1994
(51) Int. Cl.: H01L 29/812, H01L 21/338, H01L 29/60

(54) **Semiconductor device with recessed gate and production method thereof**

(30) Priority: 05.03.1993 JP 44868/93
(71) Applicant: MITSUBISHI DENKI KABUSHIKI KAISHA, Tokyo 100 (JP)
(72) Inventor: Kohno, Yasutaka, c/o Mitsubishi Denki K. K., Itami-shi, Hyogo 664 (JP)
(74) Representative: KUHNEN, WACKER & PARTNER

(57) **Abstract**

A high output semiconductor device (101) mounting a plurality of FET elements (101 a) on a semi-insulating semiconductor substrate (1), comprises a prescribed conductivity type semiconductor layer (2) formed on the semi-insulating semiconductor substrate (1), a plurality of source and drain electrodes (10a, 10b) alternatingly arranged on the semiconductor layer (2), a plurality of gate electrodes (10) respectively disposed in gate recesses (110), each recess is formed by etching each surface region of the semiconductor layer (2) between each adjacent source and drain electrodes (10a, 10b). The gate recess (110) has the asymmetrical two-stage recess structure having a second bottom surface (112a) only at the source side part of the side wall of the recess (110), wherein the second bottom surface (112a) is positioned at a depth between a first bottom surface (111 a) in contact with the gate electrode (10) and the upper surface of the semiconductor layer (2) and is not in contact with the gate electrode (10). Therefore, the thickness (Da2) of the active layer at the source side part is larger that that (Da1) in the one-stage recess structure, with a result that the source resistance is reduced because of an increase in the thickness (Da2) of the active layer at the source side region while avoiding deterioration of the gate drain breakdown voltage due to an increase in the thickness of the active layer at the drain side region.

## Description

### FIELD OF THE INVENTION

The present invention relates to a semiconductor device and a production method thereof, and more particularly to a structure of a recess (hereinafter referred to as "a gate recess") in which a gate electrode is disposed in a field effect transistor (hereinafter referred to as "FET") and a formation method thereof.

### BACKGROUND OF THE INVENTION

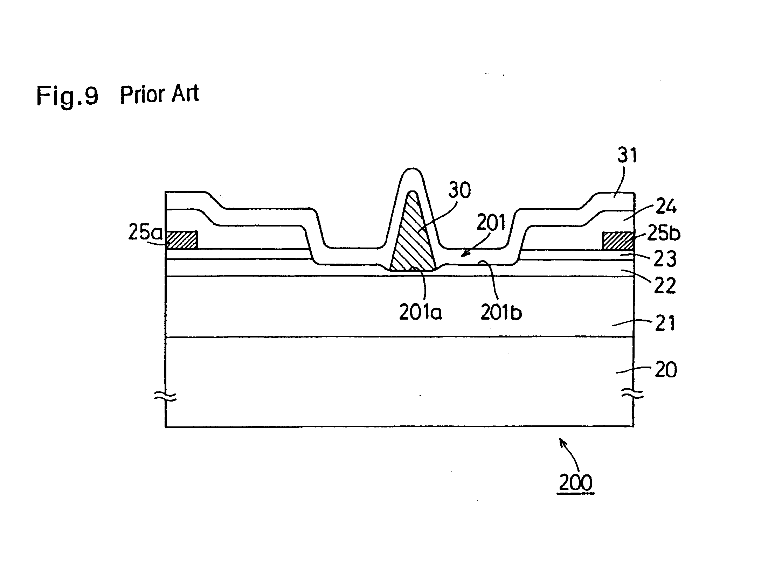

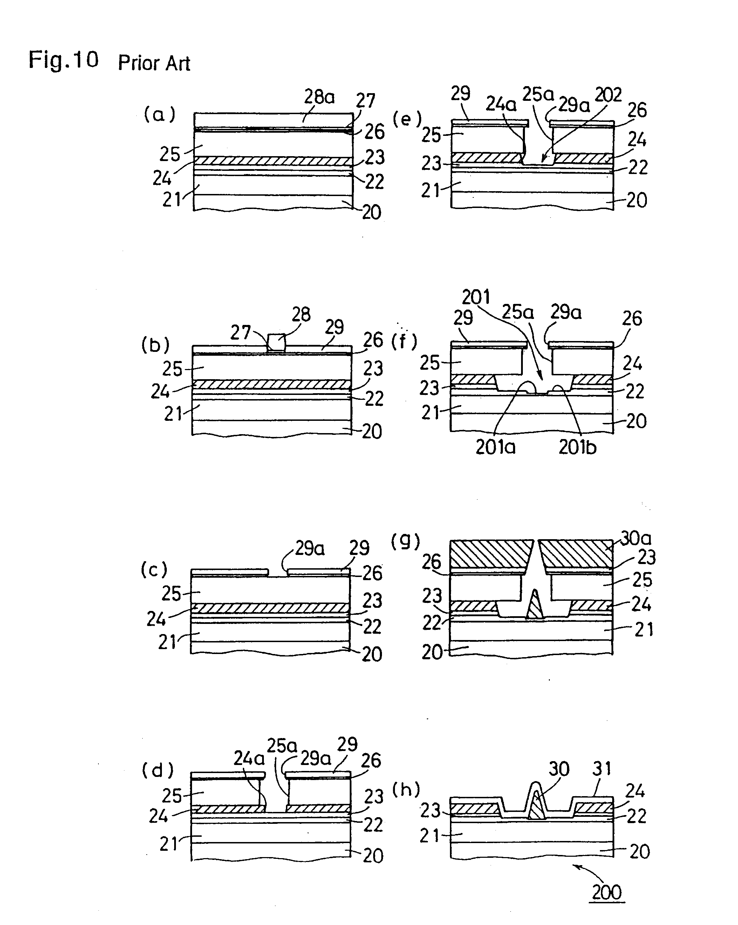

Figures 9 and 10 are views for describing a two-stage recess structure FET recited in Proceedings of SOTAPOCS XIII, p. 79, where figure 9 is a cross-sectional view showing a structure of a gate electrode part of the FET, and figures 10(a) to 10-(h) are cross-sectional views showing the major process steps in the production method of the FET.

In the figures, reference numeral 200 designates an FET of a two-stage recess structure. An n type GaAs layer 22 is formed on a GaAs substrate 20 via a GaAs buffer layer 21, and a gate electrode 30 is disposed at the center part in the gate recess 201 which is formed at a prescribed region on the n type GaAs layer 22. The gate recess 201 is provided in a two-stage recess structure having a first recess bottom surface 201 a which is provided at the central portion of the bottom surface and which is in contact with the gate electrode 30, and having second recess bottom surfaces 201 b at the both sides of the first recess bottom surface 201 a, which the second recess bottom surfaces 201 b are positioned at a depth between the first recess bottom surface 201 a and the upper surface of the n type GaAs layer 22 and which are not in contact with the gate electrode 30.

High concentration n type GaAs layers 23 are formed on the upper surface of the n type GaAs layer 22 at the both sides of the gate recess 201, and a source and a drain electrodes 25a and 25b are disposed on these n type GaAs layers 23. The upper surfaces of the high concentration n type GaAs layers 23 and the source and the drain electrodes 25a and 25b are covered with Si0₂ films 24, and a passivation film 31 comprising a SiN film is formed on the entire surfaces of the Si0₂ films 24, the n type GaAs layer 22, and the gate electrode 30.

In addition, a mask layer 25 comprising a polyimide film is provided so as to be used for evaporation and lift-off of a gate electrode material. Ni gilding layers 29 are provided for patterning the mask layer 25. A Au layer 26 is provided so as to serve as a feeding layer while forming the Ni gilding layers 29 by selective gilding. A photoresist mask 28 is provided so as to perform the Ni gilding selectively. A Ti thin film 27 formed between the Au layer 26 and the photoresist mask 28 is provided so as to enhance the adhesion between the photoresist mask 28 and the Au layer 26 and to reduce reflection at exposure of a photoresist film 28a.

A description will be given of the production method. Particularly, the process of forming the gate electrode after forming the source and the drain electrodes will be described.

First of all, the GaAs buffer layer 21, the n type GaAs layer 22, and the high concentration n type GaAs layer 23 are successively formed on the GaAs substrate 20 by epitaxial growth method, and the Si0₂ film 24 and the polyimide film 25 are successively deposited on the high concentration n type GaAs layer 23, and the Au thin film 26 and the Ti thin film 27 are formed on the polyimide film 25, and the photoresist film 28a is plated on the entire surface, as shown in figure 10(a). Here, the source and the drain electrodes are not illustrated, but they are already formed at a prescribed region on the high concentration n type GaAs layer 23.

Subsequently, the photoresist film 28a is patterned thereby to form the photoresist mask 28, and thereafter, a part of the Ti layer 27 exposed by this patterning is removed by RIE (reactive ion etching) using CBrF₃ gas, and the Ni layers 29 are selectively grown by gilding on the exposed part of the Au layer 26, as shown in figure 10(b).

Next, the photoresist mask 28 and the Ti layer 27 are removed as shown in figure 10(c), and thereafter, a part of the polyimide layer 25 exposed to the aperture of the Ni gilding layer 29 is selectively etched by RIE using 0₂ thereby to form a polyimide layer aperture 25a, and further, a part of the Si0₂ film 24 exposed to the polyimide layer aperture 25a is selectively etched by RIE using CF₄ gas thereby to form a Si0₂ film aperture 24a, as shown in figure 10(d).

Next, a part of the high concentration n type GaAs layer 23 exposed to the Si0₂ film aperture 24a is recess etched to a depth of approximately 500 A (50 nm) thereby to form a recess 202 as shown in figure 10(e), and thereafter, the Si0₂ film 24, the high concentration n type GaAs layer 23, and the n type GaAs layer 22 are etched so as to enter an undercutting of about 0.6 /1.m deep thereby to form the gate recess 201 as shown in figure 10(f). In this etching, because the n type GaAs layer 23 is previously etched as shown in figure 10(e), the gate recess 201 becomes to have a two-stage configuration having the first bottom surface 201 a which is in contact with the gate electrode and is positioned at the center part in the recess, and having the second bottom surfaces 201 b which are not in contact with the gate electrode and are positioned at a little higher position than the first bottom surface 201 a at the both sides of the first bottom surface.

Thereafter, Ti, Pt, Au as gate electrode materials 30a are successively evaporated as shown in figure 10(g), the gate electrode material 30a are lifted-off by removing the polyimide layer 25 thereby to form the gate electrode 30, and finally, the SiN film 31 is deposited on the entire surface as a passivation film, thereby providing the FET 200 of the two-stage recess structure as shown in figure 10(h).

Next, the relation between the gate recess structure and the element characteristics of the FET will be described with reference to the comparison of the two-stage recess structure and the one-stage recess structure.

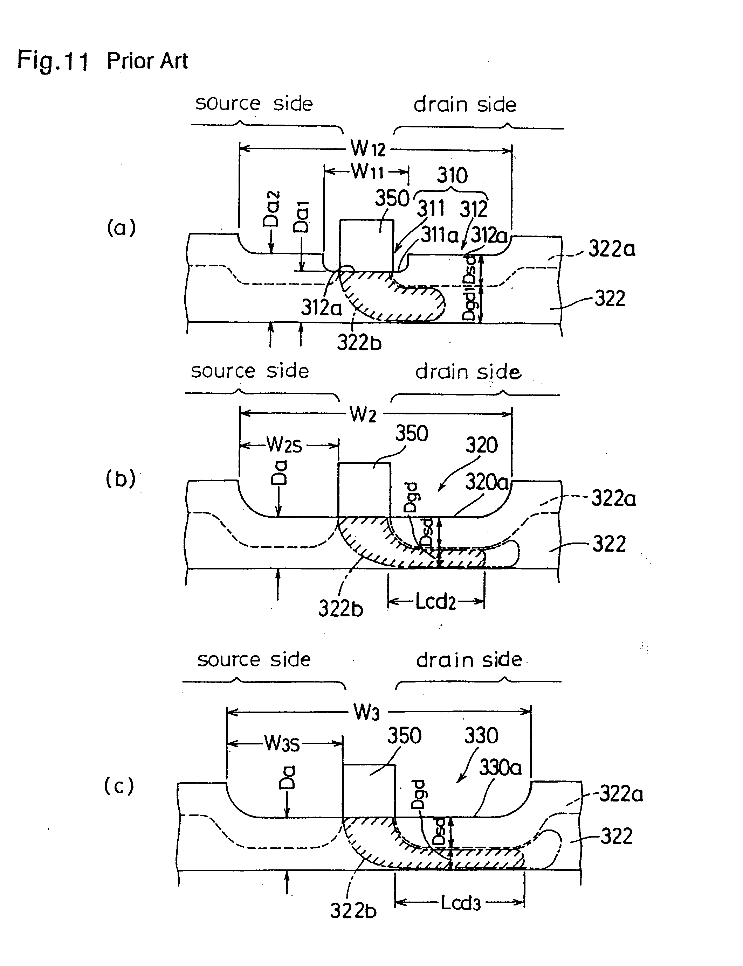

Figures 11 (a) to 11 (c) are diagrams schematically showing the two-stage recess structure, the one-stage recess structure, and the one-stage recess structure having a wide recess width in FETs, respectively. In the figures, a two-stage recess structure gate recess 310 is provided in an n type semiconductor layer 322, and the two-stage recess structure gate recess 310 is constituted by a first-stage recess 311 of an aperture width W11 having a bottom surface 311 a on which a gate electrode 350 is disposed and a second-stage recess 312 of an aperture width W12 having a bottom surface 312a positioned at a higher position than the bottom surface 311 a of the first-stage recess 311. Reference numerals 320 and 330 designate a gate recess of the one-stage recess structure having aperture widths of W2 and W3 (> W2), and having recess bottom surfaces 320a and 330a, respectively. Reference numeral 322a designates a surface depletion layer of the n type semiconductor layer 322 having a thickness Dsd. Reference numeral 322b designates a gate depletion layer extending toward the drain side along the lower surface of the surface depletion layer 322a with an increase in the gate voltage.

Because the bottom surfaces 312a of the second-stage recess 312 are positioned at the both sides of the bottom surface 311 a of the first-stage recess 311 on which the gate electrode 350 is disposed in the gate recess 310 in the two-stage recess structure FET as shown in figure 11 (a), the active layer thickness Da2 at the side of the gate electrode is thicker than the active layer thickness Da at the side of the gate electrode of the gate recess 320 in the one-stage recess structure FET shown in figure 11(b). Therefore, the two-stage recess structure FET shown in figure 11 (a) is unlikely to be subject to the influences of the channel confinement in which the path of current flowing through between the source and the drain is narrowed due to the surface depletion layer 322a generated at the upper surface of the n type semiconductor layer 322 as compared with the one-stage recess structure FET shown in figure 11 (b), with a result that preferable input and output characteristics of the FET is obtained.

Furthermore, it is known that in the two-stage recess structure FET even when the thickness Da1 of the n type semiconductor layer 322 at a part directly below the gate electrode is the same as that Da in the one-stage recess structure FET, the active layer thickness at the source side part in the gate recess is larger than that in the one-stage recess structure FET as described above, so that the source resistance is lowered as compared with in the one-stage recess structure FET, and it is advantageous to improvement in the performance of FETs.

Generally, the following factors are important for further improvement of high frequency characteristic and output characteristic of FETs: (1) suppression of the channel confinement, (2) reduction of the source resistance, and (3) improvement of the gate drain breakdown voltage. The two-stage recess structure is effective to realize the factors (1) and (2) as described above.

By the way, it is known that the gate drain breakdown voltage greatly depends on the ratio of the thickness of an active layer at the side of a gate electrode to the thickness of a surface depletion layer at the same part, and that the gate drain breakdown voltage increases with an increase in the ratio of the surface depletion layer, as recited in IEEE Trans Electron Devices, Vol. ED-276, 1013, 1980. Accordingly, in the two-stage recess structure, because the ratio of the surface depletion layer thickness to the active layer thickness at the side of the gate electrode (Dsd/Da2) is smaller than that ratio in the one-stage recess structure (Dsd/Da), the gate drain breakdown voltage is deteriorated, resulting in a problem.

More particularly, in FETs, when the voltage applied to the gate electrode 350 is increased, the gate depletion layer 322b does not extend in the thickness direction of the active layer (hereinafter referred to as "vertical direction") but extends in the transverse direction, and the gate drain breakdown voltage is determined depending on the distance of the gate depletion layer 322b extending in the transverse direction, and the gate drain breakdown voltage is large as this distance is large. To be more concrete, because the thickness Da2 of the active layer at the side of the gate electrode in the two-stage recess structure shown in figure 11-(a) is larger than that Da in the one-stage recess structure shown in figure 11 (b), the distance of the gate depletion layer 322b extending in the vertical direction, i.e., a value Dgd1 which is obtained by subtracting the surface depletion layer thickness Dsd from the thickness Da2 of the active layer at the side of the gate electrode, is larger than that value Dgd (= Da - Dsd) in the one-stage recess structure shown in figure 11 (b). Therefore, the gate depletion layer 322b is unlikely to extend in the transverse direction in the two-stage recess structure as compared with in the one-stage recess structure, resulting in a low gate drain breakdown voltage.

Besides, it is generally known that the gate drain breakdown voltage is improved with an increase in the recess width, and this is obvious from the above description. In a recess structure of a large recess width, however, while the gate drain breakdown voltage is increased, the source resistance is increased because of an increase in the recess width at the source electrode side, resulting in a problem.

More particularly, in the recess structure having the large recess width W3 as shown in figure 11 (c), because the gate depletion layer 322b does not extend in the vertical direction and the distance Lcd3 of the gate depletion layer extending toward the drain side is longer than that Lcd2 of figure 11-(b), the gate drain breakdown voltage is high, but on the other hand, because the recess width W3s at the source electrode side is larger than that W2s of figure 11 (b), an increase in the source resistance is induced.

By the way, in Japanese Published Patent Applications No. 60-28275 and No. 4-39941 are disclosed FETs having a gate recess structure in which a gate electrode is disposed on a concave part of an upper surface of a semiconductor substrate, and having an intermediate bottom surface only at the source side part of the side surface of the concave part, which intermediate bottom surface is positioned at a depth between the bottom surface of the concave part and the upper surface of the substrate.

The thicknesses of the active layers are large at the source side beside the gate and are small at the drain side beside the gate, so that the FETs have low source resistances and no deterioration of the gate drain breakdown voltage. However, because the techniques of these references include dry etching and ion implantation which are carried out in the diagonal direction against the substrate surface during the formation process of the recess structure, an arrangement of a source and a drain electrodes with respect to the gate electrode is restricted by the diagonal direction processes, resulting in a problem that when a high output transistor is produced by arranging a plurality of transistors, degree of freedom in the arrangement of the source and the drain electrodes is badly reduced.

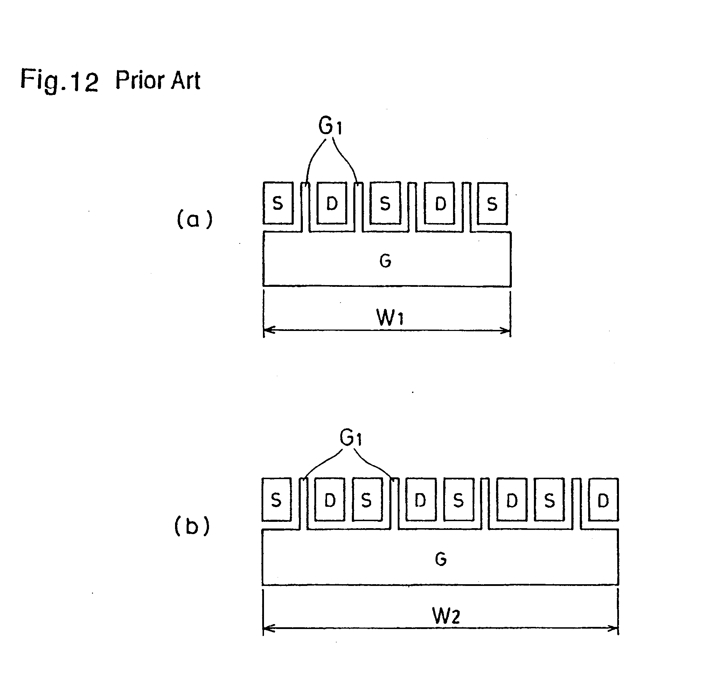

More particularly, it is general in high output transistors that source electrodes S and drain electrodes D are arranged alternatingly and gate electrodes (hereinafter referred to as "gate finger") G₁ extending from a gate part G are disposed respectively between the adjacent source and drain electrodes as shown in figure 12(a). In the techniques recited in the above-described references, however, the arrangement of source and drain electrodes with respect to gate fingers is subject to restriction, so that all the source and drain electrodes must be disposed at the same positions with respect to all the gate fingers, that is, each the source electrode S must be disposed at the left side of each the gate finger G₁ and each the drain electrode D must be disposed at the right side of each the gate finger G₁ as shown in figure 12(b), resulting in a problem that the arrangement of the source and the drain electrodes is thus restricted. Moreover, the arrangement of the source and drain electrodes like this increases the degree of extension of the FET in the transverse direction, resulting in a possibility of inducing deterioration of the FET characteristics.

Besides, in the prior art production method of the two-stage recess structure, since the gate electrode is formed by the evaporation and lift-off method as recited in the respective above-described references, a refractory metal cannot be used as a gate material, with a result that an FET having high reliability is not obtained. The reason for this is that the refractory metal melts at a high temperature and the high temperature of the refractory metal material at the evaporation process induces damage to photoresist for lift-off.

### SUMMARY OF THE INVENTION

It is an object of the present invention to provide a semiconductor device having high reliability in which a reduction in the source resistance is accomplished without inducing deterioration of the gate drain breakdown voltage, and further, there is no possibility of deterioration of the characteristics due to an arrangement of a source and a drain electrodes with respect to a gate electrode.

It is another object of the present invention to provide a production method of a semiconductor device by which an FET having a low source resistance and no deterioration of the gate drain breakdown voltage is produced without being restricted on an arrangement of a source and a drain electrodes with respect to a gate electrode by the production process, and further, in the production method, a refractory metal is used as a gate electrode material.

It is still another object of the present invention to provide a semiconductor device in which a reduction in the source resistance as well as an improvement of the gate drain breakdown voltage is accomplished.

It is still another object of the present invention to provide a production method of a semiconductor device by which an FET of a low source resistance is produced while controlling the gate drain breakdown voltage of the FET.

It is still another object of the present invention to provide a semiconductor device in which a reduction in the source resistance is accomplished while suppressing deterioration of the gate drain breakdown voltage, and further, while relaxing the channel confinement.

It is still another object of the present invention to provide a production method of a semiconductor device by which an FET of a low source resistance is produced while controlling deterioration of the gate drain breakdown voltage and suppression of the channel confinement which are in the trade-off relation, and further, in the production method, a refractory metal is used as a gate electrode material.

Other object and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, a semiconductor device comprises a plurality of source electrodes and drain electrodes which are alternatingly arranged on a semiconductor layer, and a plurality of gate electrodes each of which is disposed in a gate recess formed by selectively etching a region of the upper surface of the semiconductor layer between each the adjacent source and drain electrodes, and the gate recess has a structure having a second bottom surface only at the source side part of the gate recess, which second bottom surface is positioned at a depth between a first bottom surface in contact with the gate electrode and the upper surface of the semiconductor layer and is not in contact with the gate electrode. Therefore, the layer thickness of the semiconductor layer at a part under the gate recess, that is, the thickness of an active layer is increased only at the source side region, with a result that a reduction in the source resistance due to an increase in the layer thickness of the active layer at the source side part is accomplished while avoiding deterioration of the gate drain breakdown voltage due to an increase in the layer thickness of the active layer at the drain side part. Further, because the gate electrodes are disposed at the respective regions of the upper surface of the semiconductor layer between the source and the drain electrodes which are alternatingly arranged, there is attained the optimum layout of the respective electrodes, in which layout, the length of the arranged elements in the electrode arrangement direction is minimized, thereby realizing the element structure of high reliability with no possibility of deterioration of the characteristics due to an increase in dimension of the elements in the electrode arrangement direction.

According to a second aspect of the present invention, a production method of a semiconductor device comprises forming a recess by selectively etching a region of an upper surface of a certain conductivity type semiconductor layer where a gate electrode is to be disposed, and performing etching selectively to the internal surface of the recess using a side wall which is remained only at the source side part inside the recess as a mask, thereby forming a gate recess having a second bottom surface only at the source side of the gate recess, which second bottom surface is positioned at a higher position than a first bottom surface in contact with the gate electrode and is not in contact with the gate electrode. Therefore, the gate recess is formed without employing diagonal direction etching or ion implantation. Whereby, an FET of a low source resistance and no deterioration of the gate drain breakdown voltage is produced without being restricted on the arrangement of the source and the drain electrodes with respect to the gate electrode by the production process.

According to a third aspect of the present invention, the above-described production method of a semiconductor device further comprises, after forming the gate recess, depositing gate electrode materials on the entire surface, and selectively removing the gate electrode materials using a mask layer formed thereon, thereby forming a gate electrode. Thus, since the mask layer for the gate electrode materials is formed after performing evaporation of the gate electrode materials, the mask layer is not exposed to the evaporation, with a result that a refractory metal, which is evaporated at a high temperature, is employed as the gate electrode material.

According to a fourth aspect of the present invention, a semiconductor device comprises source electrodes and drain electrodes disposed on an upper surface of a certain conductivity type semiconductor layer with prescribed intervals, and gate electrodes respectively disposed in gate recesses. Each of the gate recess is formed by etching each region of the upper surface of the semiconductor layer between the source and the drain electrodes, and has a structure having a second bottom surface only at the source side part of the side surface of the gate recess, which second bottom surface is positioned at a depth between a first bottom surface in contact with the gate electrode and the upper surface of the semiconductor layer and is not in contact with the gate electrode, and in which structure, the distance from the drain side end of the recess aperture to the drain side end of the gate electrode is larger than the distance from the source side end of the recess aperture to the source side end of the gate electrode. Therefore, the source resistance is reduced because of an increase in the layer thickness of the active layer at the source side part, and moreover, the gate drain breakdown voltage is enhanced because the width of the gate depletion layer extending toward the drain side without extending in the thickness direction of the active layer is increased.

According to a fifth aspect of the present invention, a production method of a semiconductor device comprises forming a recess by etching a part of an upper surface of a certain conductivity type semiconductor layer where a gate electrode is to be disposed up to exposing a semiconductor thin film which is included in the semiconductor layer and which has a different composition from that of the semiconductor layer, and thereafter, using a first side wall which is remained only at the source side inside the recess as a mask, carrying out transverse direction etching to the semiconductor layer on the semiconductor thin film and vertical direction etching to the semiconductor thin film and the semiconductor layer located therebelow successively, thereby forming a gate recess of the two-stage structure having a second bottom surface only at the source side part of the gate recess, which second bottom surface is positioned at a higher position than a first bottom surface in contact with the gate electrode and is not in contact with the gate electrode. Therefore, at the formation of the gate recess, the distance from the drain side end of the recess aperture to the drain side end of the gate electrode is easily controlled by selectively performing the transverse direction etching to the semiconductor thin film.

According to a sixth aspect of the present invention, a semiconductor device comprises source electrodes and drain electrodes disposed on a certain conductivity type semiconductor layer with prescribed intervals, and gate electrodes respectively disposed in gate recesses which are formed by etching regions of the upper surface of the semiconductor layer between the source and the drain electrodes. Each the gate recess has the two-stage structure having second bottom surfaces at the source side part and the drain side part of the gate recess, which second bottom surfaces are positioned at a depth between a first bottom surface in contact with the gate electrode and the upper surface of the semiconductor layer and are not in contact with the gate electrode, and in which structure, the distance from the drain side end of this second bottom surface to the gate side end thereof is larger than the distance from the source side end of the second bottom surface to the gate side end thereof. Therefore, the source resistance is reduced because of an increase in the layer thickness of the active layer at the source side part, and further, the channel confinement is relaxed because of an increase in the layer thickness of the active layer at the drain side part, and besides, deterioration of the gate drain breakdown voltage due to an increase in the layer thickness of the active layer at the drain side part is suppressed because of making the distance from the drain side end of the second bottom surface to the gate side end thereof larger than the distance from the source side end of the second bottom surface to the gate side end thereof.

According to a seventh aspect of the present invention, a production method of a semiconductor device comprises forming a recess by etching a part of an upper surface of a certain conductivity type semiconductor layer where a gate electrode is to be disposed up to exposing a semiconductor thin film which is included in the semiconductor layer and which has a different composition from that of the semiconductor layer, and thereafter, etching the semiconductor layer on the semiconductor thin film in the transverse direction using a first side wall which is remained only at the source side inside the recess as a mask, and further, etching the semiconductor thin film and the semiconductor layer located therebelow in the recess successively using second side walls which are formed in the recess as a mask, thereby forming a gate recess of the two-stage recess structure having second bottom surfaces at the source side and the drain side of the gate recess, which second bottom surfaces are positioned at a higher position than a first bottom surface in contact with the gate electrode and are not in contact with the gate electrode, and in which structure, the distance from the drain side end of this second bottom surface to the gate side end thereof is larger than the distance from the source side end of the second bottom surface to the gate side end thereof. Therefore, at the formation of the gate recess, the distance from the drain side end of the second bottom surface to the gate side end thereof is controlled by the etching amount of the n type GaAs layer on the AIGaAs thin film. Whereby deterioration of the gate drain breakdown voltage and suppression of the channel confinement, which are in the trade-off relation in connection with the thickness of the active layer at the drain side of the gate recess, are adjusted appropriately, with a result that an FET of a desired output characteristic is easily produced.

### BRIEF DESCRIPTION OF THE DRAWINGS

Figure 1 is a diagram for describing a high output transistor as a semiconductor device in accordance with a first embodiment of the present invention.
Figure 2 is a diagram illustrating process steps in a production method of the high output transistor of the first embodiment, from an n type semiconductor layer formation process to a process of forming a recess by performing selective etching to a region of the semiconductor layer where a gate electrode is to be formed.
Figure 3 is a diagram illustrating a process step of forming a gate recess by processing the above-described recess and a process step of forming a gate electrode and a source and a drain electrodes in the production method of the high output transistor of the first embodiment.
Figure 4 is a cross-sectional view illustrating a structure of an FET as a semiconductor device in accordance with a second embodiment of the present invention.
Figure 5 is a diagram illustrating process steps in a production method of the FET of the second embodiment, from an n type semiconductor layer formation process to a process of forming a recess by performing selective etching to a region of the semiconductor layer where a gate electrode is to be formed.
Figure 6 is a diagram illustrating a process step of forming a gate recess by processing the above-described recess and a process step of forming a gate electrode and a source and a drain electrodes in the production method of the FET of the second embodiment.
Figure 7 is a cross-sectional view illustrating a structure of an FET as a semiconductor device in accordance with a third embodiment of the present invention.
Figure 8 is a diagram for describing a production method of the FET of the third embodiment.
Figure 9 is a diagram illustrating a cross-sectional structure of a prior art FET.
Figure 10 is a cross-sectional view for describing a production method of the prior art FET.
Figure 11 is a diagram for describing a relation between a gate recess configuration and element characteristics in the prior art FET with reference to the comparison of a two-stage recess structure FET and a one-stage recess structure FET.
Figure 12 is a diagram for describing problems in FETs produced by production methods of a semiconductor device recited in Japanese Published Patent Applications No. 60-28275 and No. 4-39941.

### DETAILED DESCRIPTION OF THE PREFERRED EMBODIMENTS

### Embodiment 1.

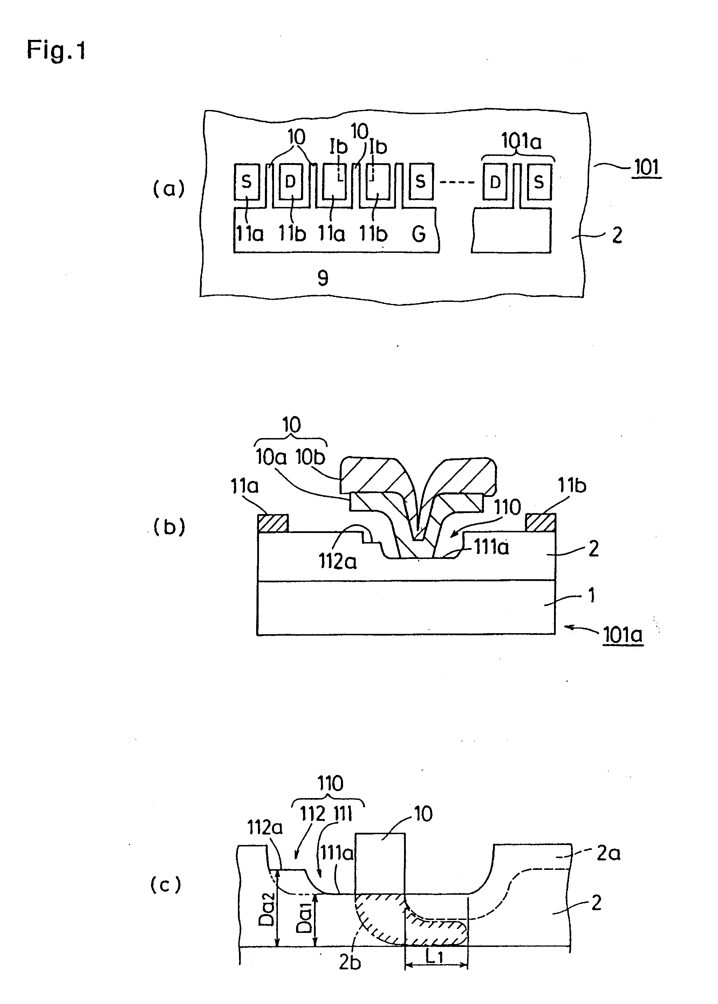

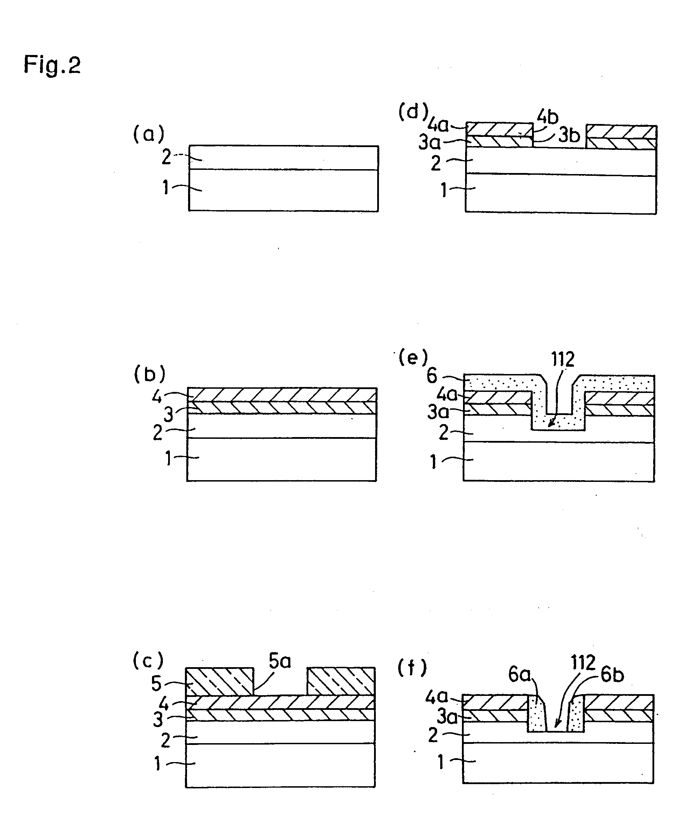

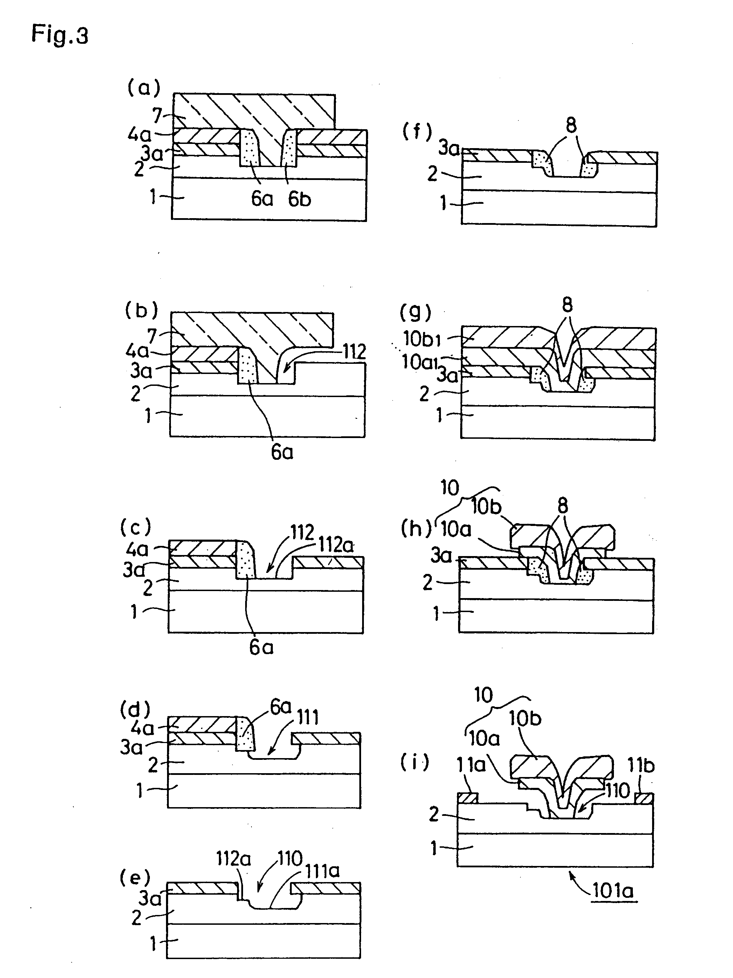

Figure 1 is a view for describing a high output transistor comprising a plurality of FET elements as a semiconductor device in accordance with a first embodiment of the present invention, where figure 1 (a) is a plan view, figure 1 (b) is a cross-sectional view of figure 1 (a) in a line Ib-Ib, and figure 1 (c) is an enlarged schematic view illustrating a gate recess part of the FET element. Figure 2 and figure 3 are view for describing a production method of the transistor, where figures 2(a) to 2(f) illustrate a production flow from an n type semiconductor layer formation process to a process of forming a concave groove at an upper surface of the semiconductor layer, and figures 3(a) to 3(i) illustrate a process for forming a gate recess by selective etching of an internal surface of the concave groove, a process of forming a gate electrode in the gate recess, and a process of forming a source and a drain electrodes.

In the figures, reference numeral 101 designates a high output transistor comprising a plurality of FET elements 101 a. An n type GaAs layer 2 of a impurity concentration of approximately 3 x 1017/_{CM3} is formed on a semi-insulating GaAs substrate 1, and source electrodes 11 a and drain electrodes 11 b are alternatingly disposed on the n type GaAs active layer 2 with prescribed intervals. The n type GaAs layer 2 has gate recesses 110 which are formed by etching the respective surface regions of the n type GaAs layer 2 between the adjacent source and drain electrodes. Gate electrodes (gate fingers) 10 extending from a gate part 9 are disposed at the center parts of the respective gate recesses 110.

The gate recess 110 has an asymmetrical two-stage recess structure having a second recess bottom surface 112a only at the source side of the side surface of the gate recess, which second recess bottom surface is positioned at a higher position than a first recess bottom surface 111 a in contact with the gate electrode 10 by a stage and is not in contact with the gate electrode 10. The gate electrode 10 is constituted by a gate Schottky metal part 10a which comprises tungsten silicide (WSi) and which is in Schottky contact with the n type GaAs layer 2 and a gate low resistance metal part 10b comprising gold (Au) of a low resistance formed on the Schottky metal part 10a. The source and the drain electrodes 11 a and 11 b are ohmic electrodes comprising AuGe/Ni/Au.

Second side walls 8 are provided for position determining the gate electrode 10 in the gate recess 110. A second insulating film 4a comprising a Si0₂ film 4 is provided for serving as a mask during formation of a second recess 112. A first insulating film 3a comprising a SiN film 3 is provided for serving as a mask during formation of a first recess 111. A source side side wall 6a and a drain side side wall 6b are formed in the second recess 112 and comprise a Si0₂ film 6. A second photoresist film 7 is provided for serving as a etching mask during selective etching of the drain side side wall 6b and the drain side part of the second insulating film 4a. A WSi layer 10a1 and a Au layer 10b1 are provided for forming the gate Schottky metal part 10a of the gate electrode 10 and the gate low resistance metal part 10b thereof, respectively.

The production method will be described.

First, n type GaAs is grown on the semi-insulating GaAs substrate 1 to approximately 4000 A (400 nm) thick by the epitaxial growth method, and thereafter, the n type GaAs other than a part at the element region where an FET element is to be produced is removed by etching or insulated by ion implantation thereby to form the n type GaAs layer 2, as shown in figure 2(a).

Next, the SiN film 3 and the Si0₂ film 4 are successively deposited on the entire surface by the plasma CVD method to approximately 1500 A (150 nm) thick respectively, as shown in figure 2(b). A photoresist film 5 is formed on the Si0₂ film 4 so as to have a photoresist aperture 5a at a position which corresponds to a part of the n type GaAs layer 2 where the gate recess 110 is to be formed, as shown in figure 2(c).

Subsequently, anisotropic reactive ion etching is carried out to the Si0₂ film 4 and the SiN film 3 successively using the photoresist film 5 as a mask, thereby forming the second and the first insulating films 4a and 3a which have apertures 4b and 3b respectively, as shown in figure 2(d).

Thereafter, anisotropic dry etching or wet etching is carried out to the n type GaAs layer 2 using the second insulating film 4a as a mask to form the second recess 112 of a depth of approximately 2500 A (250 nm), and thereafter, the Si0₂ film 6 is deposited to approximately 5000 A (500 nm) thick on the entire surface, as shown in figure 2(e). Here, figure 2(e) shows a case where the second recess 112 is formed by the dry etching.

Next, etching back of the Si0₂ film 6 is carried out by anisotropic reactive ion etching using a mixed gas of CHF₃ and 0₂, thereby forming the side walls 6a and 6b inside the second recess 112, as shown in figure 2(f).

Next, photoresist is applied to the entire surface and is patterned thereby to form the second photoresist film 7 so as to cover the entire surface except a part of the second insulating film 4a at the drain side, as shown in figure 3(a). The drain side part of the second insulating film 4a and the drain side side wall 6b are removed selectively against the first insulating film 3a and the n type GaAs layer 2 by performing wet etching using BHF in aqueous solution employing the second photoresist film 7 as a mask, as shown in figure 3(b).

Subsequently, the second photoresist film 7 is removed as shown in figure 3(c), and thereafter, isotropic dry etching or wet etching is carried out to the exposed part of the bottom surface 112a of the second recess 112 so as to selectively etch the second recess bottom surface 112a to approximately 500 A (50 nm) depth using the first and second insulating films 3a and 4a and the source side side wall 6a as a mask, thereby forming the first recess part 111. Thus, there is formed the gate recess 110 having the asymmetrical two-stage recess structure that has the second recess bottom surface 112a only at the source side part of the side surface of the gate recess, which second recess bottom surface 112a is positioned at a higher position than the first recess bottom surface 111 a in contact with the gate electrode 10 by a stage and is not in contact with the gate electrode 10, as shown in figure 3(d).

Next, the second insulating film 4a and the source side side wall 6a are removed with BHF in aqueous solution as shown in figure 3(e), and further, the second side walls 8 are formed inside the gate recess 110 as shown in figure 3(f). Thereafter, the gate electrode 10 and the source and the drain electrodes 11 a and 11 are formed as shown in figures 3(g) to 3(i).

More particularly, the WSi layer 10a1 and the Au layer 10b1 are successively formed on the entire surface by the sputtering method as shown figure 3(g). Thereafter, employing a prescribed mask (not illustrated) which is formed thereon, the Au layer 10b1 is selectively removed by the ion milling method and the WSi layer 10a1 is selectively removed by the reactive ion etching method using the mixed gas of CF₄ and 0₂, thereby forming the gate electrode 10 as shown in figure 3(h).

At last, AuGe, Ni, and Au are successively laminated, and they are alloyed by heat treatment to form the source and the drain ohmic electrodes 11 a and 11 b at both sides of the gate recess 110 on the n type GaAs layer 2 as shown in figure 3(i), thereby completing the high output transistor 101 comprising a plurality of the FET elements 101 a.

In the high output transistor 101 of this first embodiment having the above-described structure, the gate recess 110 of each the FET element has the asymmetrical two-stage recess structure having the second recess bottom surface 112a only at the source side of the side surface of the gate recess 110, which second recess bottom surface is positioned at a higher position than the first recess bottom surface 111 a in contact with the gate electrode 10 and is not in contact with the gate electrode 10. Therefore, as shown in figure 1 (c), the thickness of the n type GaAs layer 2 at the part under the gate recess 110, i.e., the thickness Da2 of the active layer is increased only at the source side region as compared with that Da1 in the one-stage recess structure which is illustrated in a two dotted chain line, resulting in an effect that a reduction in the source resistance is accomplished because of an increase in the layer thickness of the active layer at the source side part while avoiding deterioration of the gate drain breakdown voltage due to an increase in the layer thickness of the active layer at the drain side part.

Further, in the high output transistor 101, the source and the drain electrodes 11 a and 11 are alternatingly arranged on the n type GaAs layer 2, and the gate electrodes 10 are respectively disposed at the regions of the n type GaAs layer 2 between these adjacent electrodes. Therefore, there is realized the optimum layout of the respective electrodes in which the length of the arranged elements in the electrode arrangement direction is minimized, thereby resulting in an effect that the element structure of high reliability with no possibility of deterioration of the characteristics due to an increase in the dimension of the transistor in the electrode arrangement direction is realized.

Moreover, in the production method of this first embodiment, after the side walls 6a and 6b are formed inside the second recess 112 which is formed by etching a prescribed region of the upper surface of the n type GaAs layer 2, the second recess bottom surface 112a is selectively etched using the side wall 6a which is remained only at the source side part in the second recess 112 as a mask. Therefore, the gate recess 110 having the second recess bottom surface 112a only at the source side of the gate recess, which second recess bottom surface 112a is positioned at a higher position than the first recess bottom surface 111 a in contact with the gate electrode 10 and is not in contact with the gate electrode 10, is formed without employing the diagonal direction etching or the diagonal direction ion implantation, thereby resulting in an effect that the high output transistor 101 comprising a plurality of the FET elements 101 a having a low source resistance and no deterioration of the gate drain breakdown voltage is produced without receiving restriction on the arrangement of the source and the drain electrodes with respect to the gate electrode by the production process.

Further in the production method of this embodiment, after the gate recess 110 is formed, the gate electrode materials 10a1 and 10b1 are deposited on the entire surface and they are selectively removed using a mask formed thereon thereby to form the gate electrode 10. Thus, since the mask layer for forming the gate electrode is formed after performing evaporation of the gate electrode materials, the mask layer is not exposed to the evaporation. Therefore, a refractory metal which is evaporated at a high temperature is used as the gate electrode material, with a result that a transistor of high reliability having no deterioration of the characteristics due to the mutual diffusion of impurity between the n type GaAs layer 2 and the gate low resistance metal part 10b of the gate electrode 10 is produced.

In addition, in the above-described production method, because the recess bottom surface is selectively etched using the side wall formed inside the recess, the transistor having the gate recess 110 of the above-described structure is produced with favorable yield.

### Embodiment 2.

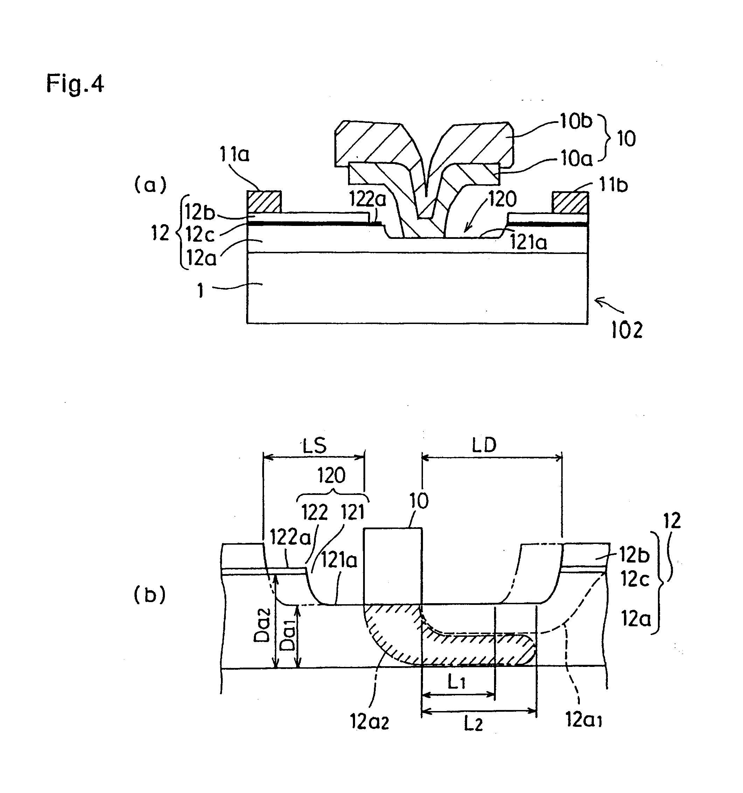

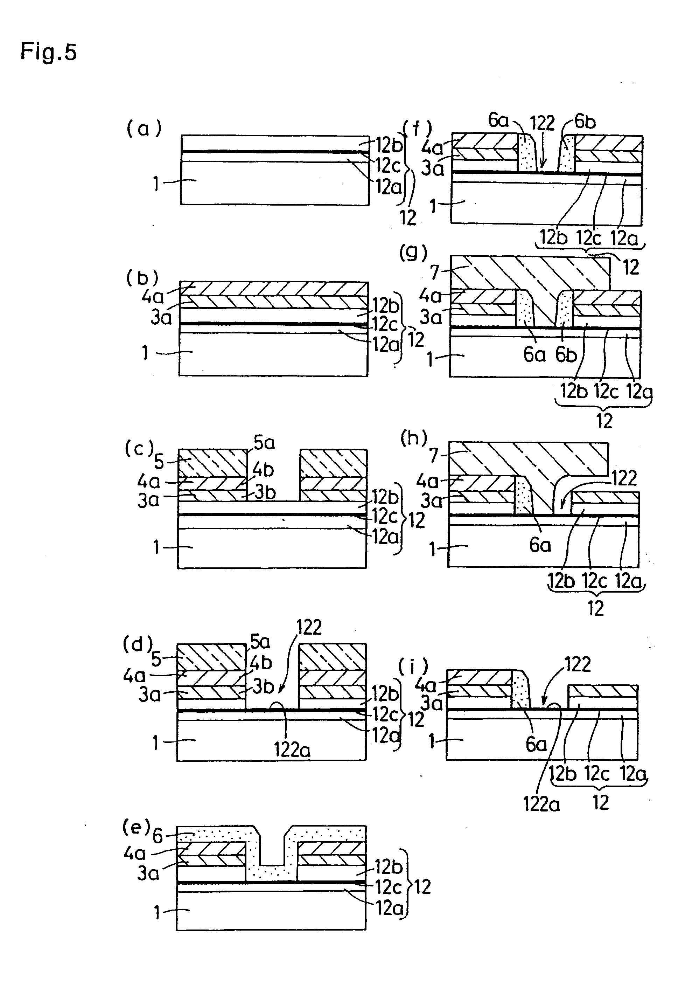

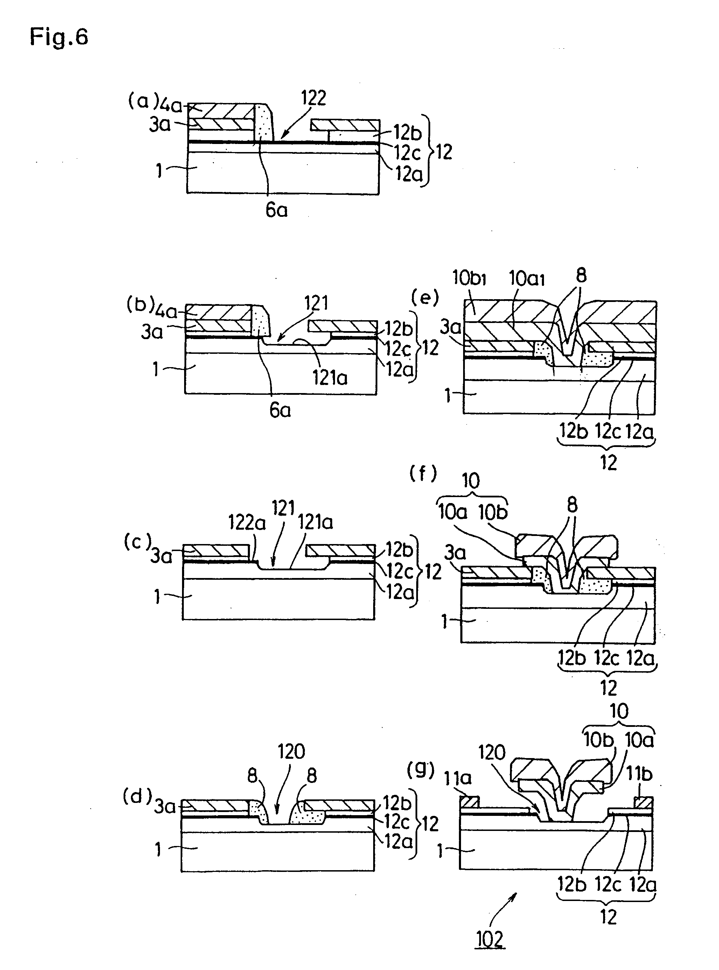

Figure 4 is a view for describing an FET as a semiconductor device in accordance with a second embodiment of the present invention, where figure 4(a) is a view illustrating a cross-sectional structure of the FET, and figure 4(b) is an enlarged schematic cross-sectional view illustrating a gate recess part of the FET. Figure 5 and figure 6 are views for describing a production method of the transistor, where figures 5(a) to 5(i) are views illustrating a production flow from an n type GaAs layer formation process to a first recess formation process, and figures 6(a) to 6(g) are cross-sectional views illustrating a process of forming a gate recess by performing etching to the internal surface of the first recess and a process of forming a gate electrode and a source and a drain electrodes.

In the figures, reference numeral 102 designates an FET of this second embodiment, in which the FET 101 a having the asymmetrical two-stage recess structure of the first embodiment is altered so as to have an offset gate structure.

More particularly, in this transistor 102, a gate recess 120 has a structure having a second recess bottom surface 122a only at the source side part of the side surface of the gate recess, in which structure, the second recess bottom surface is positioned at a higher position than a first recess bottom surface 121 a in contact with the gate electrode 10 and is not in contact with the gate electrode 10, and the distance LD from the drain side end of the gate recess aperture to the drain side end of the gate electrode 10 is larger than the distance LS from the source side end of the gate recess aperture to the source side end of the gate electrode 10.

An n type GaAs layer 12 of this transistor 102 is constituted by a lower GaAs layer 12a formed on a semi-insulating GaAs substrate 1, an AIGaAs thin film 12c grown to about 50 A (5 nm) thick on the GaAs layer 12a, and an upper GaAs layer 12b grown on the AIGaAs thin film 12c. Other construction of the transistor 102 is the same as that of the FET of the first embodiment shown in figures 1 to 3, and reference numeral 12a1 designates a surface depletion layer and reference numeral 12a2 designates a gate depletion layer.

The production method will be described.

First, as shown in figure 5(a), n type GaAs as the lower semiconductor layer 12a is grown to approximately 1500 A (150 nm) thick on the semi-insulating GaAs substrate 1 by the epitaxial growth method, and successively, AlₓGa₁-ₓAs (x = 0.2 to 0.4) is grown to about 50 A (5 nm) thick thereby to form the AIGaAs thin film 12c as an etching stopper layer, and further, the upper n type GaAs layer 12b of approximately 2500 A (250 nm) thickness is formed by growing n type GaAs. Thereafter, similarly to the first embodiment, element separation is carried out to form an n type GaAs active layer 12 at the element region. Here, an InGaAs thin film may be used as the etching stopper layer in place of the AIGaAs thin film.

Thereafter, the same processes as those shown in figures 2(b) to 2(d) of the first embodiment are carried out, thereby forming a first and a second insulating films 3a and 4a respectively having apertures 3b and 4b on a part of the n type GaAs layer 12 where the gate recess is to be formed, as shown in figures 5(b) and 5(c).

Next, in this second embodiment, the upper GaAs layer 12b is dry-etched up to exposing the AIGaAs thin film 12c using the second insulating film 4a as a mask to form a second recess 122 as shown in figure 5(d). Then, RIE using SF₆ and CI₂ gases is adopted as the condition of the dry etching, whereby the upper GaAs layer 12b is removed with high selectivity against the AIGaAs thin film 12c.

Next, the same processes as those shown in figures 2(e) and 2(f) and figures 3(a) to 3(c) of the first embodiment are carried out, thereby forming a side wall 6a only at the source side part on the second recess bottom surface 122a as shown in figures 5(e) to 5(i).

After that, in this embodiment, the upper GaAs layer 12b on the AIGaAs thin film 12c is undercut by performing high selectivity RIE using SF₆ and CI₂ gases employing the source side side wall 6a as a mask, that is, the upper GaAs layer 12b is etched in the transverse direction toward the drain side as shown in figure 6(a). Then, because selectivity of the GaAs layer against the AIGaAs thin film is high, the n type GaAs layer 12 is not etched in the depth direction.

Next, wet etching is performed to the AIGaAs thin film 12c and the GaAs layer 12a located therebelow successively using the first and the second insulating films 3a and 4a and the source side side wall 6a as a mask to dig the second recess bottom surface 122a further by approximately 500 A (50 nm) depth, thereby forming a first recess 121. Thus, the gate recess 120 having the second recess bottom surface 122a only at the source side part of the side surface of the gate recess 120, which second recess bottom surface 122a is positioned at a higher position than the first recess bottom surface 121 a in contact with the gate electrode 10 by a stage and is not in contact with the gate electrode 10, as shown in figure 6(b).

Successively, the second insulating film (Si0₂ film) 4a and the source side side wall (Si0₂ film) 6a are removed selectively against the first insulating film (SiN film) 3a using BHF in aqueous solution as shown in figure 6(c), and thereafter, second side walls 8 are formed inside the gate recess 120 by the same method as that for forming the first side walls 6a and 6b, as shown in figure 6(d).

Thereafter, the same processes as those shown in figure 3(g) and figure 3(h) of the first embodiment are carried out, thereby forming the gate electrode 10, as shown in figures 6(e) and 6-(f). Then, the gate electrode 10 is position determined by the second side walls 8 so that the distance LD from the drain side end of the gate electrode 10 to the drain side aperture end of the gate recess 120 is larger than the distance LS from the source side end of the gate electrode 10 to the source side aperture end of the gate recess 120.

At last, a source and a drain electrodes 11 a and 11 are formed as in the process shown in figure 3(i), thereby completing the FET 102 of this second embodiment as shown in figure 6(g).

As described above, in this second embodiment, becausae the gate recess 120 has the structure in which the distance LD from the drain side end of the gate recess aperture to the drain side end of the gate electrode 10 is larger than the distance LS from the source side end of the gate recess aperture to the source side end of the gate electrode 10 in addition to the construction of the first embodiment, the source resistance is reduced because of an increase in the layer thickness of the active layer at the source side part (Da2 - Da1), and besides, the width L2 of the gate depletion layer 12a2 extending toward the drain side without extending in the vertical direction becomes larger than that L1 of the first embodiment, with a result that the gate drain breakdown voltage is improved.

Further in the production method of this embodiment, the part of the upper surface of the n type GaAs layer 12 where the gate electrode 10 is to be disposed, is etched up to exposing the Al-GaAs thin film 12c which is included in the n type GaAs layer 12 and has a different composition from that of the n type GaAs layer 12 thereby to form the second recess 122. Thereafter, using the first side wall 6a which is remained only at the source side part inside the second recess 122 as a mask, the upper n type GaAs layer 12b on the AIGaAs thin film 12c is etched in the transverse direction, and the AIGaAs thin film 12c and the GaAs layer 12a located therebelow are successively etched in the vertical direction, resulting in an effect that when the gate recess 120 having the two-stage structure only at the source side part of the side surface of the gate recess is formed, the distance LD from the drain side end of the recess aperture to the drain side end of the gate electrode is easily controlled by performing the transverse direction selective etching to the AIGaAs thin film 12c.

### Embodiment 3.

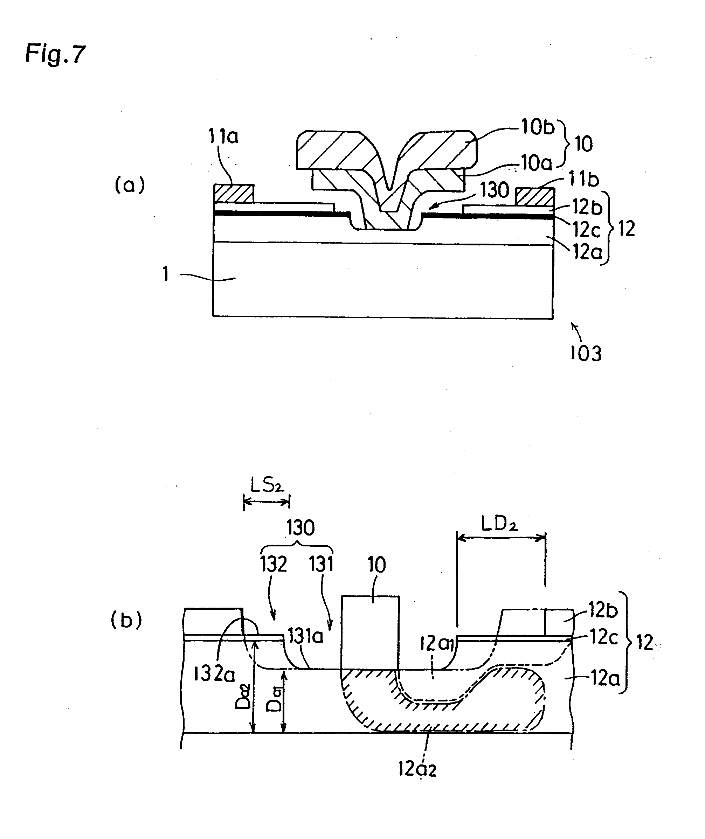

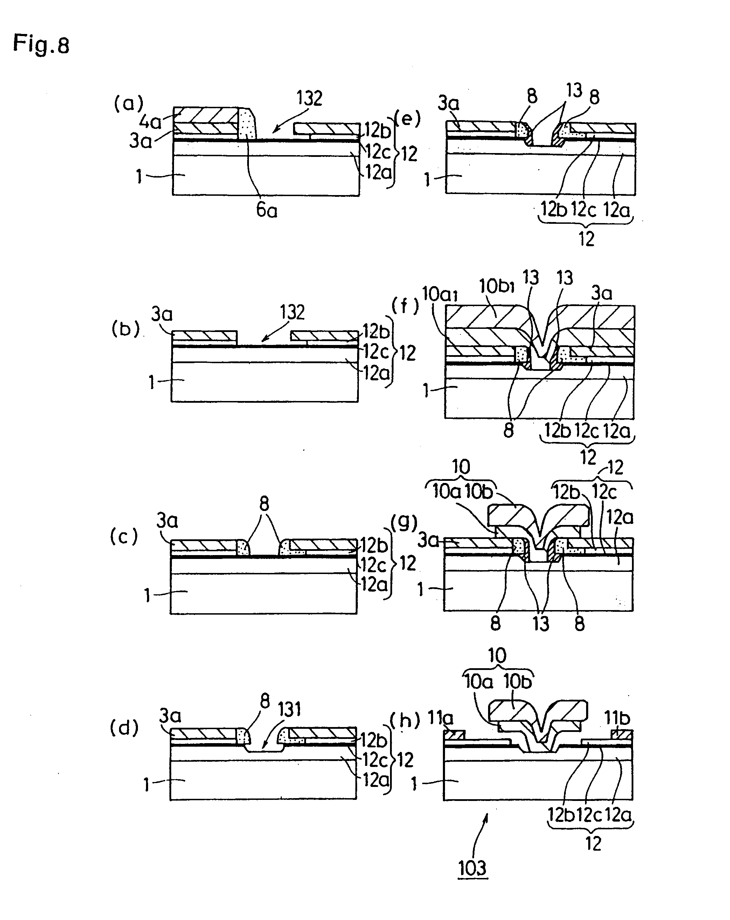

Figure 7 is a view for describing an FET as a semiconductor device in accordance with a third embodiment of the present invention, where figure 7(a) is a view illustrating a cross-sectional structure of the FET, and figure 7(b) is an enlarged schematic cross-sectional view illustrating a gate recess part of the FET. Figure 8 is a view for describing a production method of the FET.

In the figures, reference numeral 103 designates an FET of this third embodiment. This FET 103 comprises a gate recess 130 having second recess bottom surfaces 132a at both the source side and the drain side of the side surface of the gate recess, which second recess bottom surfaces are positioned at a higher position than a first recess bottom surface 131 a in contact with a gate electrode 10 by a stage and are not in contact with the gate electrode 10, and besides, the gate recess has the asymmetrical two-stage recess structure in which a distance LD2 from the drain side end of the second bottom surface 132a to the gate side end thereof is larger than a distance LS2 from the source side end of the second bottom surface 132a to the gate side end thereof. The other construction of the transistor 103 is the same as that of the second embodiment.

The production method will be described.

As described in the second embodiment, an n type GaAs layer 12 is formed on a semi-insulating GaAs substrate 1, the second recess 132 is formed at a prescribed region of the upper surface of the n type GaAs layer 12, and thereafter, an upper n type GaAs layer 12b is undercut using a side wall 6a which is remained only at the source side inside the second recess 132 as a mask, as shown in figure 8(a).

Thereafter, in this third embodiment, a second insulating film (Si0₂ film) 4a and the side wall 6a are removed selectively against first insulating films (SiN film) 3a using BHF in aqueous solution as shown in figure 8(b), and second side walls 8 are formed inside the second recess 132 as shown in figure 8(c).

Next, wet etching is carried out to an AIGaAs thin film 12c and an n type GaAs layer 12a located therebelow successively using the second side walls 8 and the first insulating films 3a as a mask to dig the second recess bottom surface 132a by approximately 500 A (50 nm) depth, thereby forming a first recess 131. Thus, the gate recess 130 of the asymmetrical two-stage recess structure having the second recess bottom surfaces 132a at the source and the drain sides of the side surface of the gate recess 132 is formed, in which structure, the second recess bottom surfaces 132a are positioned at a higher position than the first recess bottom surface 131 a in contact with the gate electrode 10 and are not in contact with the gate electrode 10, and besides, the distance LD2 from the drain side end of the second bottom surface 132a to the gate side end thereof is larger than the distance LS2 from the source side end of the second bottom surface 132a to the gate side end thereof, as shown in figure 8(d).

Next, third side walls 13 are formed inside the first recess 131 so as to cover the second side walls 8, and thereafter, the same processes as those of the first embodiment shown in figures 3(g) to 3(i) are carried out, and the gate electrode 10, a source and a drain electrodes 11 a and 11 are formed, thereby completing the FET 103 of this third embodiment, as shown in figures 8(f) to 8(h).

As described above, in this third embodiment, because the gate recess 130 has the structure in which the second recess bottom surfaces 132a are positioned at a higher position than the first recess bottom surface 131 a in contact with the gate electrode 10 and are not in contact with the gate electrode 10, and besides, the distance LD2 from the drain side end of the second bottom surface 132a to the gate side end thereof is larger than the distance LS2 from the source side end of the second bottom surface 132a to the gate side end thereof, the source resistance is reduced because of an increase (Da2 - Da1) in the layer thickness of the active layer at the source side part, and further, the channel confinement is relaxed because of an increase (Da2 - Da1) in the layer thickness of the active layer at the drain side part, and besides, deterioration of the gate drain breakdown voltage due to an increase in the layer thickness of the active layer at the drain side part is suppressed because of making the distance LD2 from the drain side end of the second bottom surface to the gate side end thereof larger than the distance LS2 from the source side end of the second bottom surface to the gate side end thereof.

Futher in the production method this embodiment, the part of the upper surface of the n type GaAs layer 12 where the gate electrode 10 is to be disposed, is etched up to exposing the AIGaAs thin film 12c which is included in the n type GaAs layer 12 and has a different composition from that of the n type GaAs layer 12 thereby to form the second recess 122. Thereafter, using the first side wall 6a which is remained only at the source side part inside the second recess 122 as a mask, the upper n type GaAs layer 12b on the AIGaAs thin film 12c is etched in the transverse direction, and using the second side wall 8 which is formed in the second recess 132, the AIGaAs thin film 12c and the GaAs layer 12a located therebelow are successively etched. Therefore, at the formation of the gate recess 130, the distance LD2 from the drain side end of the second bottom surface 132a to the gate side end thereof is controlled by the etching amount of the n type GaAs layer 12b on the AIGaAs thin film 12c. Whereby deterioration of the gate drain breakdown voltage and suppression of the channel confinement, which are in the trade-off relation in connection with the thickness of the active layer at the drain side of the gate recess, are adjusted appropriately, with a result that an FET of a desired output characteristic is easily produced.

## Claims

1. A high output semiconductor device (fig. 1) that has mounted a plurality of field effect transistor elements (101 a) on a semi-insulating semiconductor substrate (1), comprising:
a prescribed conductivity type semiconductor layer (2) formed on said semi-insulating semiconductor substrate (1);
a plurality of source electrodes (11 a) and drain electrodes (11 b) alternatingly arranged on said semiconductor layer (2);
a plurality of gate electrodes (10) respectively disposed in gate recesses (110) formed by etching respective regions of the upper surface of said semiconductor layer (2) between each mutually adjacent source electrode (11 a) and drain electrode (11 b); and
said gate recess (110) being provided in a structure having a second bottom surface (112a) only at the source side part of said recess (110), wherein said second bottom surface (112a) is positioned at a depth between a first bottom surface (111 a) in contact with said gate electrode (10) and the upper surface of said semiconductor layer (2) and is not in contact with said gate electrode (10).

2. A production method of a semiconductor device for producing a field effect transistor (figs. 2, 3), comprising;
forming a prescribed conductivity type semiconductor layer (2) on a semi-insulating semiconductor substrate (1), and depositing a first insulating film (3) and a second insulating film (4) successively on said semiconductor layer (2);
selectively etching said first and second insulating films (3, 4) successively, thereby to form apertures (3b, 4b) of the same pattern on both said first and second insulating films (3a, 4a);
forming a recess (112) at the upper surface of said semiconductor layer (2) by etching a part thereof exposed to said insulating film apertures (3b, 4b);
forming a first side wall (6a) inside said recess so as to cover only the source side part of the internal side surface of said recess (112);
performing etching to the internal surface of said recess (112) using said first side wall (6a) as a mask, thereby to form a second bottom surface (112a) only at the source side part of said recess (110), said second bottom surface (112a) positioned at a depth between a first bottom surface (111 a) in contact with said gate electrode (10) and the upper surface of said semiconductor layer (2) and being not in contact with said gate electrode (10); and
removing said second insulating film (4a) and said first side wall (6a), and thereafter, forming second side walls (8) for position determining said gate electrode (10) in said gate recess (110).

3. The production method of a semiconductor device of claim 2 (figs. 2, 3), wherein said process of forming said first side wall (6a) comprises, after forming said recess (112), forming a first side wall (6a, 6b) inside said recess by depositing an insulating film and performing etching back thereto, and etching off portions of said second insulating film (4a) and said first side wall (6b) so as to remain portions of these only at the source side using a photoresist mask (7).

4. The production method of a semiconductor device of claim 2 (figs. 2. 3), further comprising, after forming said second side walls (8), depositing a gate electrode material (1 Oa1, 10bl) on the entire surface, and selectively removing said gate electrode material (1 Oa1, 10b1) employing a mask layer formed on said gate electrode material (1 Oa1, 10b1), thereby forming a gate electrode (10).

5. A semiconductor device (fig. 4), comprising:
a prescribed conductivity type semiconductor layer (12) formed on a semi-insulating semiconductor substrate (1) and having a gate recess (120) formed by selectively etching a prescribed region of the upper surface of said semiconductor layer (12);
a gate electrode (10) disposed in said gate recess (120) formed on said semiconductor layer (12);
a source electrode (11 a) and a drain electrode (11 b) disposed on an, upper surface of said semiconductor layer (12) at both sides of said gate recess (120); and
said gate recess (120) provided in a structure having a second bottom surface (122a) only at the source side part of said recess (120), wherein said second bottom surface (122a) is positioned at a depth between a first bottom surface (121 a) in contact with said gate electrode (10) and the upper surface of said semiconductor layer (12) and is not in contact with the gate electrode (10), and the distance (LD) from the drain side end of said recess aperture to the drain side end of said gate electrode (10) is larger than the distance (LS) from the source side end of said recess aperture to the source side end of said gate electrode (10).

6. A production method of a semiconductor device for producing a field effect transistor (figs. 5. 6), comprising;
forming a prescribed conductivity type semiconductor layer (12: 12a, 12b, 12c) on a semi-insulating semiconductor substrate (2) so as to have a semiconductor thin film (12c) interposed therein which having a different composition from that of said semiconductor layer (12a, 12b), and depositing a first insulating film (3a) and a second insulating film (4a) successively on said semiconductor layer (12);
selectively etching said first and said second insulating films (3a, 4a) successively, thereby to form insulating film apertures (3b, 4b) of the same pattern on the respective insulating films (3a, 4a);
etching a part of said semiconductor layer (12b) exposed in said insulating film apertures (3b, 4b) up to exposing said semiconductor thin film (12c), thereby to form a recess (122) at the upper surface of said semiconductor layer (12b);
forming a first side wall (6a) inside said recess (122) so as to cover only the source side part of the internal side surface of said recess (122);
selectively etching only a part of said semiconductor layer (12b) on said semiconductor thin film (12c), which part is exposed at the drain side part of said internal side surface of said recess (122), using said first side wall (6a) as a mask; and
performing etching to said semiconductor thin film (12c) which is exposed to said recess (122) and said semiconductor layer (12a) located therebelow successively using said first side wall (6a) as a mask, thereby to form a gate recess (121) having a second bottom surface (122a) only at the source side part of the side surface of said recess (120), said second bottom surface (122a) positioned at a depth between a first bottom surface (121 a) in contact with a gate electrode (10) and the upper surface of said semiconductor layer (12b) and being not in contact with said gate electrode (10).

7. The production method of a semiconductor device of claim 6 (figs. 5, 6), wherein said process of forming said first side wall (6a) comprises, after forming said recess (122), forming a first side wall (6a, 6b) inside said recess by depositing an insulating film and performing etching back thereto, and etching off parts of said second insulating film (4a) and said first side wall (6b) so as to remain parts of these only at the source side using a photoresist mask (7).

8. The production method of a semiconductor device of claim 6 (figs. 5, 6), further comprising, after removing said second insulating film (4a) and said first side wall (6a), forming second side walls (8) for position determining said gate electrode (10) in said gate recess (120) so that the distance (LD) from the drain side end of said recess aperture to the drain side end of said gate electrode (10) is larger than the distance (LS) from the source side end of said recess aperture to the source side end of said gate electrode (10).

9. The production method of a semiconductor device of claim 8 (figs. 5, 6), further comprising, after forming said second side walls (8), depositing a gate electrode material (1 Oa1, 10bl) on the entire surface, and selectively removing said gate electrode material (1 Oa1, 10b1) employing a mask layer formed on said gate electrode material (1 Oa1, 10b1), thereby producing a gate electrode (10).

10. A semiconductor device (fig. 7), comprising:
a prescribed conductivity type semiconductor layer (12: 12a, 12b, 12c) formed on a semi-insulating semiconductor substrate (1) and having a gate recess (130) formed by selectively etching a prescribed region of the upper surface of said semiconductor layer (12);
a gate electrode (10) disposed in said gate recess (130) formed on said semiconductor layer (12);
a source electrode (11 a) and a drain electrode (11 b) disposed on an upper surface of said semiconductor layer (12) at both sides of said gate recess (130); and
said gate recess (130) provided in a structure having second bottom surfaces (132a) at the source side part and the drain side part of said recess (130), wherein said second bottom surfaces (132a) are positioned at a depth between a first bottom surface (131 a) in contact with said gate electrode (10) and the upper surface of said semiconductor layer (12b) and are not in contact with the gate electrode (10), and the distance from the drain side end of said second bottom surface (132a) to the gate side end thereof is larger than the distance from the source side end of said second bottom surface (132a) to the gate side end thereof.

11. A production method of a semiconductor device for producing a field effect transistor (fig. 8), comprising:
forming a prescribed conductivity type semiconductor layer (12: 12a, 12b, 12c) on a semi-insulating semiconductor substrate (1) so as to have a semiconductor thin film (12c) interposed therein having a different composition from that of said semiconductor layer (12a, 12b), and depositing a first insulating film (3a) and a second insulating film (4a) successively on said semiconductor layer (12);
selectively etching said first and second insulating films (3a, 4a) successively, thereby to form insulating film apertures of the same pattern on the respective insulating films (3a, 4a);
etching a part of said semiconductor layer (12b) exposed in said insulating film apertures up to exposing said semiconductor thin film (12c), thereby to form a recess (132) at the upper surface of said semiconductor layer (12);
forming a first side wall (6a) inside said recess (132) so as to cover only the source side part of the internal side surface of said recess (132);
selectively etching only a part of said semiconductor layer (12b) on said semiconductor thin film (12c), which part is exposed at the drain side part of said recess(132), using said first side wall (6a) as a mask;
removing said second insulating film (4a) and said first side wall (6a), and thereafter, forming second side walls (8) inside said recess (132);
performing etching to a part of said semiconductor thin film (12c) exposed to said recess (132) and a part of said semiconductor layer (12a) located therebelow successively, thereby to form a gate recess (131) provided in a structure having second bottom surfaces (132a) at the source side part and the drain side part of said recess, wherein said second bottom surfaces (132a) are positioned at a depth between a first bottom surface (131 a) in contact with said gate electrode (10) and the upper surface of said semiconductor layer (12) and are not in contact with said gate electrode (10), and the distance from the drain side end of said second bottom surface (132a) to the gate side end thereof is larger than the distance from the source side end of said second bottom surface (132a) to the gate side end thereof; and
forming third side walls (13) for position determining said gate electrode (10) in said gate recess (131) so as to cover said second side walls (8).

12. The production method of a semiconductor device of claim 11 (fig. 8), wherein said process of forming said first side wall (6a) comprises, after forming said recess (132), forming first side wall inside said recess (132) by depositing an insulating film and performing etching back thereto, and etching off parts of said second insulating film (4a) and said first side wall so as to remain parts of these only at the source side.

13. The production method of a semiconductor device of claim 11 (fig. 8), further comprising, after forming said third side walls (13), depositing a gate electrode material (1 Oa1, 10b1) on the entire surface, and selectively removing said gate electrode material (1 Oa1, 10b1) employing a mask layer formed on said gate electrode material (10al, 10b1), thereby forming a gate electrode (10).
